# EUROPÄISCHE PATENTSCHRIFT

(11) **EP 3 571 515 B1**
(45) Veröffentlichungstag und Bekanntmachung des Hinweises auf die Patenterteilung: **22.02.2023**
(21) Anmeldenummer: 18700746.3
(22) Anmeldetag: 16.01.2018
(51) Int. Cl.: G01R 31/12, G01R 31/58, H01B 7/32

(54) **OPTISCHER ISOLATIONSWÄCHTER UND VERFAHREN ZU DESSEN VERWENDUNG UND HERSTELLUNG**
OPTICAL INSULATION-MONITORING DEVICE AND METHODS FOR USING AND PRODUCING SAME
CONTRÔLEUR D'ISOLATION OPTIQUE ET PROCÉDÉ D'UTILISATION ET DE FABRICATION DUDIT CONTRÔLEUR

(30) Priorität: 19.01.2017 DE 102017200840
(43) Veröffentlichungstag der Anmeldung: 27.11.2019
(73) Patentinhaber: Fraunhofer-Gesellschaft zur Förderung der angewandten Forschung e.V., 80686 München (DE)
(72) Erfinder: SCHADE, Wolfgang, 38644 Goslar (DE)
(74) Vertreter: Friese Goeden Patentanwälte PartGmbB
(86) Internationale Anmeldenummer: PCT/EP2018/050979
(87) Internationale Veröffentlichungsnummer: WO 2018/134188

(56) Entgegenhaltungen:
- EP-A1- 0 539 915
- EP-A1- 1 712 942
- EP-A1- 2 725 398
- WO-A1-2010/078609
- WO-A1-2012/134301
- WO-A1-2013/148630
- WO-A2-02/071111
- CN-U- 204 117 620
- CN-U- 205 508 498
- DE-A1- 4 240 266
- US-A1- 2010 226 609
- US-A1- 2010 277 329
- US-A1- 2013 187 630
- US-A1- 2013 335 102
- US-B1- 6 559 437
- US-B1- 7 154 081
- US-B1- 9 391 700

## Beschreibung

Die Erfindung betrifft einen optischen Isolationswächter für Stromkabel mit einem Lichtwellenleiter zur Transmission eines optischen Messsignals, eine Isolationsüberwachungseinrichtung und ein Kabel mit einem derartigen optischen Isolationswächter sowie dessen Verwendung und ein Verfahren zu dessen Herstellung.

Isolationswächter überwachen in Stromnetzen den Isolationszustand von Stromkabeln eines IT-Netzes und geben bei Unterschreitung eines minimalen Isolationswiderstandes ein Alarmsignal. Ein IT-System, auch IT-Netz genannt, ist eine Realisierungsart eines Niederspannungsnetzes zur elektrischen Stromversorgung in der Elektrotechnik mit erhöhter Ausfallsicherheit bei Erdschlussfehlern.

Anwendungsbereiche von Isolationswächtern sind Überwachungen von Stromversorgungen, bei denen ein einfacher Fehler, z.B. ein einpoliger Erdschluss, nicht zu einem Ausfall der Stromversorgung führen darf. Beispiele derartiger Stromversorgungen sind Krankenhäuser, Kraftwerke, Photovoltaikanlagen oder Elektromobilität. Insbesondere bei Schnellladestationen für Elektrofahrzeuge sind besonders hohe Sicherheitsanforderungen zu erfüllen, da hier Ladespannungen bis 950 V bei Stromstärken bis 500 A eingesetzt werden.

Insbesondere an Schnellladekabel, welche zum "Betanken" von Elektrofahrzeugen eingesetzt werden, werden besondere Sicherheitsanforderungen gestellt. Hier ist der Security Integrated Level 3 (SIL 3) in Anlehnung der DIN 61508 zu erfüllen, welcher ein Erkennen eines Defektes des standardmäßig eingebauten Isolationswächters und die dann anschließende Übernahme der Isolationsüberwachung erfüllen muss. Es ist dazu eine Redundanz des bestehenden Systems zur Isolationsüberwachung vorzusehen.

Es ist bekannt, die Isolation von Stromkabeln, z.B. eines Ladekabels, dadurch zu überwachen, dass das Ladekabel mit einer Glas- oder Polymerfaser als Lichtwellenleiter umwickelt wird. Dazu wird Licht als ein optisches Messsignal in den Lichtwellenleiter eingekoppelt und die Transmission des Lichtes am Lichtaustrittsende des Lichtwellenleiters detektiert. Biegungen des Ladekabels führen zu einer Änderung der transmittierten Lichtintensität. Bei einer vollständigen Zerstörung des Lichtwellenleiters wird die Lichtleitung unterbrochen. Diese Signaländerungen lassen sich mit einer Photodiode am Lichtaustrittsende des Lichtwellenleiters detektieren und auswerten. Dabei können geringe Schädigungen der Isolation des Stromkabels (Kabelmantel) und das Eindringen z.B. eines Nagels zwischen einzelnen vom Lichtwellenleiter ausgebildeten Umwicklungen nicht eindeutig detektiert werden, da die den Lichtwellenleiter ausbildende Faser dabei nicht zwangsläufig vollständig zerstört wird, obwohl die Isolation signifikant beschädigt sein kann. Insbesondere, wenn die Lichtübertragung durch den Lichtwellenleiter nicht vollständig unterbrochen ist, können dabei Beschädigungen der Isolation nicht eindeutig von durch Biegung des Ladekabels verursachten Transmissionsverlusten unterschieden werden.

US 2013/335102 A1 beschreibt ein Datenkabel mit einem Manipulationsschutz, welcher insbesondere ein Abhören der übertragenen Daten verhindern soll.

US 2010/277329 A1, US 7 154 081 B1, US 6 559 437 B1 befassen sich im Wesentlichen mit der Messung einwirkender Spannungen und Temperaturen um drohende Schäden erkennen zu können.

Aufgabe der vorliegenden Erfindung ist es, einen Isolationswächter und ein Verfahren zu dessen Herstellung sowie Verwendung bereitzustellen, welcher eine verbesserte Detektion von Beschädigungen der Isolation eines Kabels ermöglicht.

Die Aufgabe wird erfindungsgemäß durch eine Vorrichtung gemäß Anspruch 1 sowie eine Verwendung nach Anspruch 13 und ein Verfahren nach Anspruch 14 gelöst. Vorteilhafte Weiterbildungen der Erfindung finden sich in den Unteransprüchen.

Ein erfindungsgemäßer optischer Isolationswächter für Stromkabel weist eine Mehrzahl von Lichtwellenleiter zur Transmission jeweils eines optischen Messsignals auf, wobei die Lichtwellenleiter in eine Polymerfolie integriert sind. Der optische Isolationswächter wird somit von einer Polymerfolie mit integrierten optischen Wellenleitern ausgebildet. Die Lichtwellenleiter können dabei in einigen Ausführungsformen der Erfindung als Multimode Wellenleiter ausgeführt sein.

Mittels des erfindungsgemäßen Isolationswächters können Beschädigungen der Isolation des Stromkabels eindeutig detektiert werden. Biegungen des Stromkabels führen zwar auch hier zu Transmissionsänderungen der Messsignale, diese lassen sich jedoch eindeutig von einer Beschädigung, bzw. Zerstörung eines einzelnen Lichtwellenleiters unterscheiden, da das in jedem Lichtwellenleiter transmittierte optische Messsignal individuell detektiert und ausgewertet werden kann. Durch einen Vergleich der einzelnen transmittierten Messsignale miteinander kann diese Unterscheidung eindeutig vorgenommen werden. Der Ausfall eines einzelnen Lichtwellenleiters und/oder eine wesentliche Abweichung der Transmission zumindest eines einzelnen Lichtwellenleiters von der Transmission der anderen Lichtwellenleiter ist dabei ein sicherer Indikator für das mechanische Eindringen eines Gegenstandes, welches zur Beschädigung des betreffenden Lichtwellenleiters und damit der Isolation geführt hat. Dieses Ereignis wird sicher und eindeutig erkannt.

In einigen Ausführungsformen der Erfindung können die Lichtwellenleiter in der Polymerfolie einen Durchmesser von etwa 0,5 mm bis etwa 2,0 mm oder von etwa 0,7 mm bis etwa 1,5 mm oder von etwa 0,8 mm bis etwa 1,3 mm aufweisen. Der Abstand benachbarter Wellenleiter innerhalb der Polymerfolie kann zwischen etwa 0 mm und etwa 2 mm oder zwischen etwa 0,1 mm und etwa 1 mm oder zwischen etwa 0,1 mm und etwa 0,5 mm betragen. Hierdurch wird eine Überwachung von nahezu der gesamten Fläche ermöglicht, so dass auch kleinste Beschädigungen erkannt werden können.

In einigen Ausführungsformen der Erfindung sind die Lichtwellenleiter in Lagen in der Polymerfolie integriert, wobei die Lichtwellenleiter einer ersten Lage versetzt zu den Lichtwellenleitern einer darüber oder darunter angeordneten zweiten Lage angeordnet sind. Derart ist zumindest ein Bereich der Polymerfolie in der Folienebene lückenlos von den Lichtwellenleitern überdeckt, ohne dass es zum unerwünschten Übersprechen zwischen benachbarten Lichtwellenleitern kommt. Bei einer derartigen geometrischen Anordnung der Lichtwellenleiter ist sichergestellt, dass beim Durchstechen der Polymerfolie in dem Bereich die Transmission zumindest eines Lichtwellenleiters unterbrochen wird.

In der Erfindung ist an den Enden der Lichtwellenleiter jeweils ein Koppelelement zur Einund/oder Auskoppelung der optischen Messsignale in die Lichtwellenleiter vorhanden. Dadurch können die Messsignale durch einfach ankoppelbare optische Module erzeugt und ausgewertet werden.

In der Erfindung enthalten die Koppelelemente jeweils einen, zwei unterschiedliche Polymere aufweisenden Bereich der Polymerfolie, wobei die unterschiedlichen Polymere sich in ihren Brechungsindizes unterscheiden. Derartige Koppelelemente werden in der vorliegenden Beschreibung als digitale Koppelelemente bezeichnet und ermöglichen die effiziente Einkopplung von Licht einer Lichtquelle, z.B. eines Flächenstrahlers, als optische Messsignale in die Lichtwellenleiter senkrecht zur Einstrahlrichtung des Flächenstrahlers. Analog ist auch die Auskopplung von Licht aus den Lichtwellenleitern in eine zur Ebene der Polymerfolie senkrechte Ebene möglich.

In einigen Ausführungsformen der Erfindung sind die Koppelelemente dazu eingerichtet, die Messsignale senkrecht zu ihrer Transmissionsrichtung in den Lichtwellenleitern umzulenken. Dies erlaubt eine besonders effiziente Ein- und Auskopplung der Messsignale in bzw. aus den Lichtwellenleitern mit einem reduzierten mechanischen Aufwand. Dazu kann jeder Wellenleiter an dessen Anfang und an dessen Ende jeweils mit einem digitalen Koppelelement verbunden sein, welches zur senkrechten Ein- bzw. Auskopplung des Lichtes in den Lichtwellenleiter dient.

In einigen Ausführungsformen der Erfindung können die Koppelelemente direkt in die Polymerfolie eingebracht sein, welche auch die Lichtwellenleiter trägt, wodurch eine besonders einfache Herstellung ermöglicht wird. Derartige digitale Koppelelemente können direkt in multimode Lichtwellenleiter eingeprägt bzw. eingeschrieben werden, beispielsweise mittels Nanoimprint oder Mikroskop-Projektions-Photolithographie (MPP) Technik, was ein kostengünstiges Verfahren zur Herstellung des erfindungsgemäßen optischen Isolationswächters darstellt.

In einigen Ausführungsformen der Erfindung sind die Koppelelemente zu mindestens einem Array zusammengefasst angeordnet. Wenn die digitalen Koppelelemente, z.B. jeweils am Anfang und Ende der Polymerfolie, zu einem Array angeordnet sind, können die Messignale und deren Transmission jeweils auf einmal, d.h. mit einem zugeordneten optischen Modul, in die Lichtwellenleiter eingekoppelt bzw. ausgelesen werden.

Insbesondere können die Koppelelemente eines Arrays zur Einkopplung (Beleuchtungs- oder Einkoppelarray) der Messsignale eingerichtet sein und die Koppelelemente eines weiteren Arrays zur Auskopplung (Auslese- oder Auskoppelarray) der Messsignale eingerichtet sein. Die Arrays dienen der flächigen Einkopplung von Licht in die Lichtwellenleiter der Polymerfolie und entsprechend der flächigen Auskopplung. Bei einer separaten Anordnung der Koppelelemente in einem Beleuchtungsarray und einem Auslesearray kann das Einkoppeln der Messsignale durch eine einzelne Lichtquelle und das Auslesen der Messsignale durch einen einzelnen Detektor insbesondere mit mehreren Detektionspixeln erfolgen, wodurch eine effiziente Einrichtung zur Isolationsüberwachung ermöglicht wird.

In einigen Ausführungsformen der Erfindung verfügt die Isolationsüberwachungseinrichtung über zumindest eine Light Emitting Diode (LED) zur Emission der Messignale, welche im Bereich des Arrays zur Einkopplung der Messsignale angeordnet ist und zumindest ein Charge Coupled Device (CCD) Kameraelement zum Auslesen der Messignale, welches im Bereich des Arrays zur Auskopplung der Messsignale angeordnet ist. In einigen Ausführungsformen erfolgt die Einkopplung durch direkte Kontaktierung der LED auf das Beleuchtungsarray, das Auslesen mit der CCD Kamera ebenfalls durch direkte Kontaktierung auf dem Auslesearray. Dies erlaubt eine mechanisch robuste und optisch effiziente Ausführung. Wird der optische Isolationswächter, d.h. die Polymerfolie, mechanisch beschädigt, so wird in einzelnen Lichtwellenleitern die Lichtführung unterbrochen und damit werden einzelne Pixel der CCD Kamera nicht mehr ausgeleuchtet.

In einigen Ausführungsformen der Erfindung wird den Lichtwellenleitern bei Betrieb der Isolationsüberwachungseinrichtung Licht einer einheitlichen Wellenlänge bzw. eines einheitlichen Wellenlängenbereiches zugeführt. Dadurch kann ein aufwändiges Wellenlängenmultiplex entfallen.

Ein erfindungsgemäßes Kabel weist ein Stromkabel und einen erfindungsgemäßen optischen Isolationswächter auf. Die Polymerfolie des optischen Isolationswächters ist derart angeordnet, dass die radiale Außenoberfläche des Stromkabels zumindest in einem überwachten Längsabschnitt des Kabels vollständig von der Polymerfolie umschlossen ist. Die Polymerfolie wird dabei derart auf das Stromkabel aufgebracht, dass sie dieses flächig umschließt.

In einigen Ausführungsformen der Erfindung kann das Kabel weiterhin eine textile Hülle aufweisen, wobei die Hülle die Polymerfolie und das Stromkabel zumindest in dem überwachten Längenabschnitt anliegend umschließt. Die Polymerfolie auf dem Stromkabel wird durch die textile Hülle, welche die Polymerfolie und das Stromkabel eng umschließt, geschützt. Die textile Hülle kann als ein Gewebe von synthetischen Chemiefasern auf der Basis von Polyethylen oder Polypropylen ausgebildet sein.

Der Schutz der Polymerfolie, die auf das Stromkabel laminiert sein kann, erfolgt durch das Textilgewebe der Hülle, welches über das Stromkabel gezogen ist. Als Material für die Hülle wird in einigen Ausführungsformen vorteilhaft ein Polyethylen Flechtgewebe verwendet, dieses mechanisch sehr resistent ist und damit das Stromkabel zusätzlich vor eventuellen mechanischen Beschädigungen schützt. Alternativ kann die Polymerfolie des optischen Isolationswächters auch in einen äußeren Gummimantel eingebracht werden. Dafür muss die Polymerfolie Temperaturen bis 250°C standhalten.

Das erfindungsgemäße Kabel eignet sich insbesondere als Schnellladekabel zur Ladung von Elektrofahrzeugen. Als Stromkabel kann dazu ein Ladekabel zur Schnellladung von Elektrofahrzeugen bekannter Art eingesetzt werden und mit dem erfindungsgemäßen optischen Isolationswächter ausgestattet werden. Für die Schnellladung kann eine Wasserkühlung und/oder Luftkühlung des Schnellladekabels vorgesehen sein um den Querschnitt des Kabels und damit verbunden das Gewicht des Kabels zu reduzieren. Ein Schaden der Isolierung eines derartigen Schnellladekabels könnte demzufolge durch Messung eines Wasser- oder Luft-Druckverlustes erfolgen, allerdings ist es damit nicht möglich, kleinste Beschädigungen der Isolierung zu detektieren, die aber andererseits bereits zu elektrischen Durchschlägen und damit zur Gefährdung von Personen bei der elektrischen Betankung führen können. Aufgrund der hohen Ladeleistungen, von z.B. etwa 500 kW, müssen daher bereits kleinste Beschädigungen der Isolation sicher detektiert werden, was mit einem erfindungsgemäßen optischen Isolationswächter möglich ist.

Der erfindungsgemäße Isolationswächter kann in einigen Ausführungsformen der Erfindung auf einer Länge zwischen etwa 20 cm und etwa 500 cm oder auf einer Länge zwischen etwa 50 cm und etwa 300 cm oder auf einer Länge zwischen etwa 80 cm und etwa 250 cm am Kabel angebracht sein. Hierdurch wird zumindest der in einer Gehäusedurchführung angeordnete Teil oder der einem Benutzerzugriff zugängliche Teil des Kabels überwacht, wohingegen andere Abschnitte des Kabels, welche durch ihre Lage ohnehin berührungsgeschützt sind, nicht überwacht werden.

Das erfindungsgemäße Verfahren zur Herstellung eines optischen Isolationswächters umfasst die Verfahrensschritte Bereitstellen einer Polymerfolie und Einbringen von Lichtwellenleitern und Koppelelementen in die Polymerfolie, wobei die Lichtwellenleiter durch Einprägen und/oder Einschreiben mit Kurzpulslaser und/oder Flexodruck eingebracht werden und/oder wobei die Koppelelemente mittels Nanoimprintdruck und/oder Mikroskop-Projektions-Photolithographie und/oder durch maskenlose Lithographie hergestellt werden.

Die Herstellung des erfindungsgemäßen optischen Isolationswächters mit Polymerfolie und den darin integrierten Lichtwellenleitern kann über das Prägeverfahren oder besonders vorteilhaft mittels Flexodruck und/oder maskenlose Lithographie erfolgen. Derart können die Lichtwellenleiter als Multimode Wellenleiterstrukturen, z.B. mit einer Breite von einem millimetern, auf Längen von mehreren Metern effizient hergestellt werden. Die Herstellung der digitalen Koppelelemente an den jeweiligen Enden der Lichtwellenleiter kann entweder mittels Nanoimprintdruck oder durch Mikroskop-Projektions-Photolithographie (MPP) effizient erfolgen. Besonders vorteilhaft wird Nanoimprintdruck zur Herstellung eingesetzt, da dabei die Wellenleiterproduktion und die Herstellung der digitalen Koppelelemente in einem Produktionsprozess erfolgen können. LEDs und CCD Kameras sind kostengünstige photonische Komponenten, Polymerfolien mit integrierten Multimode Wellenleitern sind ebenfalls kostengünstige Komponenten, so dass sich mit einer derartigen Gesamtanordnung einer Isolationswächtereinrichtung sehr kostengünstige optische Isolationswächter für die Schnellladung von Elektrofahrzeugen herstellen lassen.

Besondere Ausführungsformen der vorliegenden Erfindung werden nachfolgend bezugnehmend auf die beiliegenden Zeichnungen näher erläutert. Es zeigen:
- Fig. 1: ein Ausführungsbeispiel eines erfindungsgemäßen Kabels mit einem erfindungsgemäßen optischen Isolationswächter.
- Fig. 2: eine Anordnung von versetzten Multimode Wellenleitern in einem erfindungsgemäßen optischen Isolationswächter.
- Fig. 3: ein Ausführungsbeispiel eines digitalen Koppelelementes an einem Ende eines Lichtwellenleiters eines erfindungsgemäßen optischen Isolationswächters.
- Fig. 4: eine Detaildarstellung des ein Beleuchtungs- und/oder Auslesearray aufweisenden Bereiches des optischen Isolationswächters des Kabels aus Figur 1.

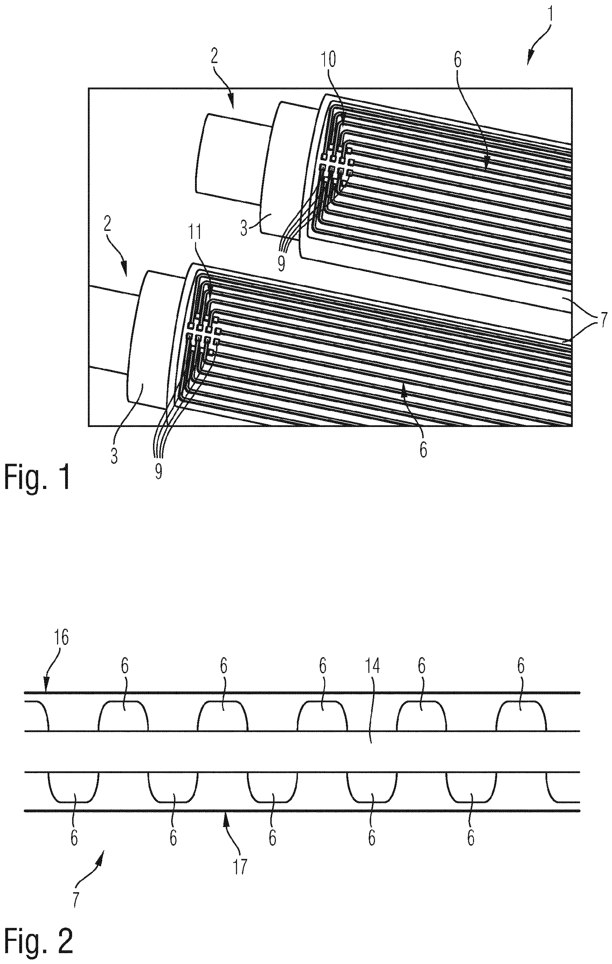

In Figur 1 ist ein Ausführungsbeispiel eines erfindungsgemäßen optischen Isolationswächters 1 dargestellt, der auf ein Stromkabel 2 mit einer Isolierung 3 aufgebracht ist. In der Darstellung sind die zwei Enden des derart aufgebauten erfindungsgemäßen Kabels dargestellt. Der optische Isolationswächter 1 weist mehrere Lichtwellenleiter 6 zur Transmission jeweils eines optischen Messsignals auf, die in eine Polymerfolie 7 integriert sind. Die Polymerfolie 7 ist auf die Außenoberfläche der Isolierung 3 auflaminiert und/oder aufgeklebt. An den Enden der Lichtwellenleiter 6 ist jeweils ein Koppelelement 9, zur Ein- und/oder Auskoppelung der optischen Messsignale in die Lichtwellenleiter 6, vorgesehen.

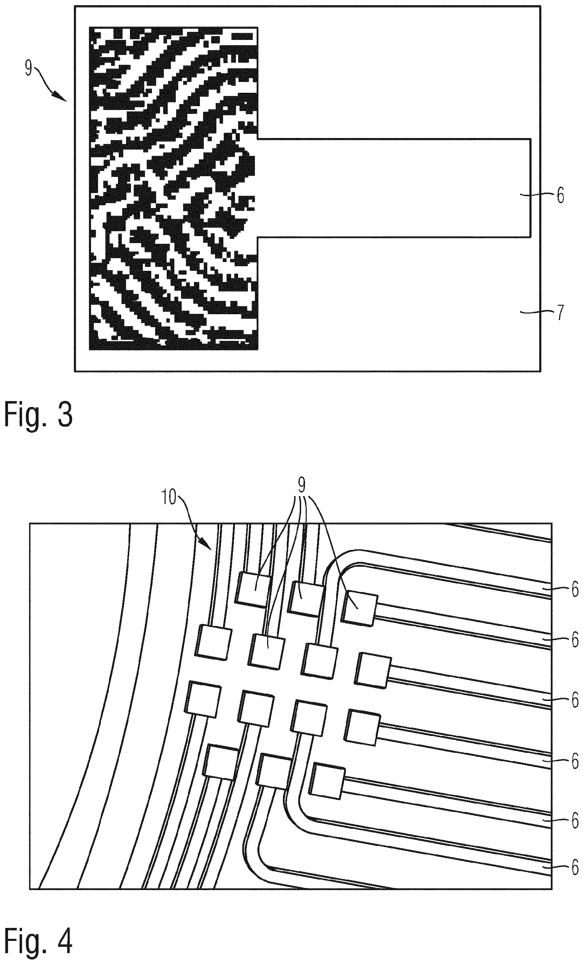

Unter der Annahme eines Kabeldurchmessers von 70 mm ergibt sich ein Umfang des Kabels von 220 mm. Somit beträgt die Anzahl der möglichen Lichtwellenleiter 6 auf Vorder- bzw. Rückseite der Polymerfolie 7 in diesem Beispiel 110 Lichtwellenleiter 6, wenn zwischen jedem Lichtwellenleiter 6 ein Millimeter Abstand besteht und die Breite der Lichtwellenleiter 6 ein Millimeter beträgt. Zur effizienten Lichteinund -auskopplung sind die einzelnen Lichtwellenleiter 6 am Ende der Polymerfolie 7 flächig zu jeweils einem ersten Array 10 und einem zweiten Array 11 zusammengefasst. Jedes einzelne Wellenleiterende ist mit einem digital strukturierten Koppelelement 9 gemäß Figur 3 versehen. Die Größe dieser Koppelelemente 9 liegt im Bereich von einem Quadratmillimeter. In Figur 1 sind derart 14 Lichtwellenleiter 6 mit integrierten Koppelelementen 9 angeordnet.

Die Koppelelemente 9 eines der zwei Arrays 10, zu denen die Koppelelemente 9 zusammengefasst sind, sind zur Einkopplung der Messsignale vorgesehen und die Koppelelemente 9 des weiteren Arrays 11 sind zur Auskopplung der Messsignale vorgesehen. Bei dem dargestellten Ausführungsbeispiel des optischen Isolationswächters 1 auf einem Ladekabel sind die integrierten flächigen digitalen Lichteinkoppel- und Lichtauskoppelelemente 9 im oben dargestellten Kabelende als Einkoppelseite und im unten dargestellten Kabelende als Auskoppelseite vorgesehen. Das Einkoppelarray 10 ist zur Beleuchtung mit einer LED vorgesehen. Das Auskoppelarray 11 ist zum flächigen Auslesen mit einer CCD Kamera vorgesehen.

Bei der Verwendung des erfindungsgemäßen optischen Isolationswächters 1 erfolgt eine eindeutige optische Isolationsüberwachung bereits kleinster mechanischer Schädigungen durch die auf das Stromkabel 2 aufgebrachte Polymerfolie 7 mit integrierten Wellenleitern 6, die z.B. das gesamte Stromkabel 2 umgibt. Die Polymerfolie 7 ist derart angeordnet, dass die radiale Außenoberfläche des Stromkabels 2 zumindest in einem überwachten Längenabschnitt des Kabels vollständig von der Polymerfolie 7 umschlossen ist. Der derart geschützte Bereich kann z.B. bei Schnelladekabeln nur im Bereich dessen Steckers, also dort, wo die Bedienung beim elektrischen Betanken (Ladevorgang) erfolgt, liegen. Er kann sich aber auch über mehrere Meter entlang des Kabels erstrecken.

In Figur 2 ist eine Anordnung von versetzten als Multimode Wellenleitern ausgeführten Lichtwellenleitern 6 in einem erfindungsgemäßen optischen Isolationswächter in einem Querschnitt durch die Polymerfolie 7 des Isolationswächters dargestellt. Die Lichtwellenleiter 6 sind in zwei Lagen in der Polymerfolie 7 integriert, wobei die Lichtwellenleiter 6 einer Lage versetzt zu den Lichtwellenleitern 6 der anderen Lage angeordnet sind. Die Lagen befinden sich jeweils auf einer Seite eines Kernbereichs 14 der Polymerfolie 7, so dass die einzelnen Lichtwellenleiter 6, obwohl der Bereich der Polymerfolie 7, in dem die Lichtwellenleiter 6 angeordnet sind, lückenlos von den Lichtwellenleitern 6 überdeckt ist, sich nicht berühren.

Die dargestellte Anordnung von versetzten Multimode Wellenleitern 6 auf Vorder- 16 und Rückseite 17 der Sensorfolie kann zur Herstellung des erfindungsgemäßen optischen Isolationswächters auf eine Polymer-Trägerfolie, welche den dargestellten Kernbereich 14 bildet, gedruckt werden. Um die lückenlose Überdeckung zu erreichen, ist die Polymerfolie 7 auf Vorder- 16 und Rückseite 17 mit optischen Multimode Wellenleitern 6 bedruckt. Die Lichtwellenleiter 6 der Vorderseite 16 sowie die Lichtwellenleiter 6 der Rückseite 17 bilden jeweils zusammen eine der Lagen der Lichtwellenleiter aus. Die Länge der Lichtwellenleiter 6 kann bis zu mehreren Metern betragen, die Breite der Lichtwellenleiter 6 liegt typischerweise bei einem Millimeter. Die Anordnung der Lichtwellenleiter 6 ist derart, dass diese überlappend angeordnet sind. Bei Beschädigung der Polymerfolie 7, beispielsweise durch Eindringen eines dünnen Nagels, wird durch die gewählte Anordnung garantiert, dass mindestens ein Wellenleiter 6 zerstört und damit die Lichtleitung, also die Transmission des Messsignals, unterbrochen wird.

In Figur 3 ist eine Photographie eines Ausführungsbeispiels eines digitalen Koppelelementes 9 an einem Ende eines Lichtwellenleiters 6 eines erfindungsgemäßen optischen Isolationswächters, wie in Figur 1 dargestellt, gezeigt. Das Koppelelement 9 ist aus einem, zwei unterschiedliche Polymere aufweisenden Bereich der Polymerfolie 7 ausgebildet, wobei die unterschiedlichen Polymere sich in ihren Brechungsindizes unterscheiden. Das dargestellte Ausführungsbeispiel eines digitalen Koppelelementes 9 erreicht 75% Lichteinkopplung in den Multimode Wellenleiter für 850 nm Lichtwellenlänge. Die beiden unterschiedlichen Bereiche sind in der Figur als die wellenartige Struktur innerhalb des Koppelelementes 9 erkennbar.

Das Koppelelement 9 stellt eine optische Komponente mit einem ein Polymer enthaltendem oder daraus bestehendem Substrat mit einem ersten Brechungsindex dar, in welchem Raumbereiche mit einem zweiten Brechungsindex ausgebildet sind, wobei die optische Komponente zumindest ein optisches Metamaterial enthält, welches eine Mehrzahl einzelner Pixel enthält, welche jeweils einen Raumbereich umfassen, welcher den ersten oder den zweiten Brechungsindex aufweist. Derart entsteht das in der Figur erkennbare Muster im Bereich des Koppelelementes. Die unterschiedliche Polymere aufweisenden Bereiche der Polymerfolie werden also durch die verschiedenen Pixel ausgebildet. Das Substrat wird von der Polymerfolie 7 gebildet.

Unter einem Metamaterial werden für die Zwecke der vorliegenden Beschreibung Materialien verstanden, welche eine künstlich hergestellte Struktur enthalten, deren, für den Brechungsindex ausschlaggebende, elektrische Permitivität und magnetische Permeabilität von den in der Natur üblichen Werten abweichen. Dies wird erreicht durch periodische, kleine Strukturen, welche im Inneren des Metamaterials ausgebildet werden. Vorliegend enthält das Metamaterial eine Mehrzahl einzelner Pixel, welche jeweils einen Raumbereich umfassen, welcher den ersten oder den zweiten Brechungsindex aufweist. Die Pixel können periodisch angeordnet sein, so dass sich quasi ein Schachbrettmuster ergibt, in welchem Pixel des einen und des anderen Brechungsindex abwechselnd angeordnet sind, wobei in den darunterliegenden Zeilen die Pixelfolge um eine Periode versetzt ist. Derart entsteht die erkennbare wellenartige Struktur. In anderen Ausführungsformen der Erfindung können die Pixel ähnlich wie in einem optischen QR-Code in einem vorgebbaren, auf den ersten Blick willkürlichen Muster angeordnet sein, so dass sich eine gewünschte, vorgebbare Wirkung des Metamaterials auf optische Signale ergibt.

In Figur 4 ist eine Detaildarstellung des ein Beleuchtungsund/oder Auslesearray 10 aufweisenden Bereiches des optischen Isolationswächters des Kabels aus Figur 1 gezeigt. Der Bildausschnitt stellt z.B. das Beleuchtungsarray der Sensorfolie dar. Die Anordnung der Koppelelemente 9 in dem Array 10 ist in einem Schachbrettmuster gewählt. Derart können die einzelnen Koppelelemente 9 einzelnen Pixeln oder Pixelbereichen eines CCD Kameraelementes zugeordnet werden.

In einer erfindungsgemäßen Isolationsüberwachungseinrichtung werden die Koppelelemente 9 des Einkoppelarrays 10 flächig beleuchtet, z.B. durch eine LED. Die Detektion des transmittierten als Messsignal eingekoppelten Lichtes aus den Koppelelementen auf der gegenüberliegenden Seite des Kabels, z.B. im Bereich des Handgriffs eines Schnelladekabels, erfolgt dabei durch eine auf das Auslesearray kontaktierte CCD Kamera. Wird die Lichtleitung in einem der Lichtwellenleiter 6 durch einen mechanischen Eingriff, d.h. eine Beschädigung des Kabels, unterbrochen, so wird von dem zugehörigen digitalen Koppelelement 9 des entsprechenden Lichtwellenleiters 6 kein Licht emittiert und entsprechend die Pixel auf der CCD Kamera nicht mehr ausgeleuchtet.

Für eine kontinuierliche Auswertung kann das Kamerabild des z.B. Schnellladekabels im unversehrten Zustand hinterlegt und anschließend als Referenz verwendet werden. Ein mechanischer Eingriff, d.h. Defekt der Isolierung des Schnellladekabels führt eindeutig zu nicht ausgeleuchteten Kamerapixeln und kann somit eindeutig von Intensitätsschwankungen, beispielsweise hervorgerufen durch Biegung des Kabels, unterschieden werden. Sowohl die LED als auch die CCD Kamera lassen sich aufgrund der geringen geometrischen Bauformen der Komponenten problemlos in das Kabel integrieren. Das Gesamtsystem benötigt keine komplizierte optische Justierung, da sowohl Beleuchtung als auch das Auslesen flächig erfolgen. Die Beleuchtung und das Auslesen der digitalen Koppelelemente auf der Rückseite der Polymerfolie, bei einer Ausführungsform z.B. gemäß Figur 2, erfolgt durch die Polymerfolie hindurch.

Die Erfindung betrifft einen Optischen Isolationswächter 1 für Stromkabel 2 mit einem Lichtwellenleiter 6 zur Transmission eines optischen Messsignals. Es ist mindestens ein weiterer Lichtwellenleiter 6 zur Transmission jeweils eines weiteren optischen Messsignals vorgesehen, wobei die Lichtwellenleiter 6 in eine Polymerfolie 7 integriert sind.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Ausführungsformen definieren, so dient diese Bezeichnung der Unterscheidung zweier gleichartiger Ausführungsformen, ohne eine Rangfolge festzulegen.

## Patentansprüche

1. Optischer Isolationswächter (1) für Stromkabel (2) mit zumindest einem Lichtwellenleiter (6) zur Transmission eines optischen Messsignals, wobei eine Mehrzahl von Lichtwellenleitern (6) vorhanden ist, welche jeweils dazu eingerichtet sind, ein zugeordnetes optisches Messsignal zu transportieren, wobei an den Enden der Lichtwellenleiter (6) jeweils ein Koppelelement (9) zur Ein- und/oder Auskoppelung der optischen Messsignale in die Lichtwellenleiter (6) vorhanden ist, **dadurch gekennzeichnet, dass**
die Lichtwellenleiter (6) in eine Polymerfolie (7) integriert sind, wobei die Koppelelemente (9) aus jeweils einem, zwei unterschiedliche Polymere aufweisendem Bereich der Polymerfolie (7) ausgebildet sind, wobei die unterschiedlichen Polymere sich in ihren Brechungsindizes unterscheiden.

2. Optischer Isolationswächter nach Anspruch 1, **dadurch gekennzeichnet, dass** die Lichtwellenleiter (6) in Lagen in der Polymerfolie (7) integriert sind, wobei die Lichtwellenleiter (6) einer Lage versetzt zu den Lichtwellenleitern (6) einer anderen Lage angeordnet sind.

3. Optischer Isolationswächter nach Anspruch 1 oder 2, die Lichtwellenleiter (6) in zumindest einer Teilfläche der Polymerfolie (7) mit lückenloser Überdeckung angeordnet sind.

4. Optischer Isolationswächter nach Anspruch 1, **dadurch gekennzeichnet, dass** die Koppelelemente (9) dazu eingerichtet sind, die Messsignale senkrecht zu ihrer Transmissionsrichtung in den Lichtwellenleitern (6) umzulenken.

5. Optischer Isolationswächter nach einem der Ansprüche 1 bis 4, **dadurch gekennzeichnet, dass** die Koppelelemente (9) in zugeordneten Teilbereichen der Lichtwellenleiter (6) eingebracht sind.

6. Optischer Isolationswächter nach einem der Ansprüche 1 bis 5, **dadurch gekennzeichnet, dass** die Koppelelemente (9) zu mindestens einem Array (10,11) zusammengefasst sind.

7. Optischer Isolationswächter nach Anspruch 6, **dadurch gekennzeichnet, dass** die Koppelelemente (9) eines ersten Arrays (10) zur Einkopplung der Messsignale eingerichtet sind und die Koppelelemente (9) eines zweiten Arrays (11) zur Auskopplung der Messsignale eingerichtet sind.

8. Isolationsüberwachungseinrichtung mit einem optischen Isolationswächter nach Anspruch 7, **dadurch gekennzeichnet, dass** eine LED zur Emission der Messignale mit dem ersten Array (10) gekoppelt ist und ein CCD-Kameraelement zum Auslesen der Messsignale mit dem zweiten Array (11) gekoppelt ist.

9. Isolationsüberwachungseinrichtung nach Anspruch 8,
**dadurch gekennzeichnet, dass** diese dazu eingerichtet ist, den Lichtwellenleitern (6) Licht einer einheitlichen Wellenlänge zuzuführen.

10. Kabel mit einem Stromkabel (2) und einem optischen Isolationswächter (1) nach einem der Ansprüche 1 bis 8, **dadurch gekennzeichnet, dass** die Polymerfolie (7) derart angeordnet ist, dass die radiale Außenoberfläche des Stromkabels (2) zumindest in einem Längenabschnitt des Kabels vollständig von der Polymerfolie (7) umschlossen ist.

11. Kabel nach Anspruch 10, **dadurch gekennzeichnet, dass** eine textile Hülle vorhanden ist, wobei die Hülle die Polymerfolie (7) und das Stromkabel (2) zumindest in dem überwachten Längenabschnitt anliegend umschließt.

12. Kabel nach Anspruch 11, **dadurch gekennzeichnet, dass** die textile Hülle ein Gewebe von synthetischen Chemiefasern auf der Basis von Polyethylen, enthält oder daraus besteht.

13. Verwendung eines Kabels nach einem der Ansprüche 10 bis 12 als Schnellladekabel zur Ladung von Elektrofahrzeugen.

14. Verfahren zur Herstellung eines optischen Isolationswächters (1) nach einem der Ansprüche 1 bis 7 mit den Verfahrensschritten: Bereitstellen einer Polymerfolie (7) und Einbringen von Lichtwellenleitern (6) und Koppelelementen (9) in die Polymerfolie (7), wobei die Lichtwellenleiter (6) durch Einprägen und/oder Einschreiben und/oder Flexodruck eingebracht werden und/oder wobei die Koppelelemente (9) mittels Nanoimprintdruck und/oder Mikroskop-Projektions-Photolithographie und/oder maskenlose Lithographie hergestellt werden, Bereitstellen eines Kabels mit zumindest einem elektrischen Leiter und Umgeben des Kabels mit der zumindest einen Polymerfolie (7) .

## Claims

1. Optical insulation-monitoring device (1) for power cables (2), having at least one optical waveguide (6) for transmitting an optical measurement signal, a plurality of optical waveguides (6) being present which are each designed to transport an associated optical measurement signal, a coupling element (9) for coupling the optical measurement signals into and/or out of the optical waveguides (6) being present at each end of the optical waveguides (6), **characterized in that**
the optical waveguides (6) are integrated into a polymer film (7), each of the coupling elements (9) being formed from a region of the polymer film (7) that has two different polymers, the different polymers differing with regard to their refractive indices.

2. Optical insulation-monitoring device according to claim 1, **characterized in that** the optical waveguides (6) are integrated in layers into the polymer film (7), the optical waveguides (6) of one layer being arranged in staggered fashion with respect to the optical waveguides (6) of another layer.

3. Optical insulation-monitoring device according to claim 1 or 2, wherein the optical waveguides (6) are arranged in at least one partial area of the polymer film (7) with complete covering.

4. Optical insulation-monitoring device according to claim 1, **characterized in that** the coupling elements (9) are designed to redirect the measurement signals perpendicularly to their transmission direction in the optical waveguides (6).

5. Optical insulation-monitoring device according to any of claims 1 to 4, **characterized in that** the coupling elements (9) are introduced in associated partial regions of the optical waveguides (6).

6. Optical insulation-monitoring device according to any of claims 1 to 5, **characterized in that** the coupling elements (9) are combined to form at least one array (10, 11).

7. Optical insulation-monitoring device according to claim 6, **characterized in that** the coupling elements (9) of a first array (10) are designed for coupling in the measurement signals and the coupling elements (9) of a second array (11) are designed for coupling out the measurement signals.

8. Insulation-monitoring apparatus having an optical insulation-monitoring device according to claim 7, **characterized in that** an LED for emitting the measurement signals is coupled to the first array (10) and a CCD camera element for reading out the measurement signals is coupled to the second array (11).

9. Insulation-monitoring apparatus according to claim 8, **characterized in that** it is designed to supply light of a uniform wavelength to the optical waveguides (6).

10. Cable having a power cable (2) and an optical insulation-monitoring device (1) according to any of claims 1 to 8, **characterized in that** the polymer film (7) is arranged in such a way that the radial outer surface of the power cable (2) is completely enclosed by the polymer film (7), at least in a longitudinal portion of the cable.

11. Cable according to claim 10, **characterized in that** a textile sheath is present, the sheath enclosing the polymer film (7) and the power cable (2) in an adjoining fashion, at least in the monitored longitudinal portion.

12. Cable according to claim 11, **characterized in that** the textile sheath contains or consists of a fabric of synthetic man-made fibers on the basis of polyethylene.

13. Use of a cable according to any of claims 10 to 12 as a fastcharging cable for charging electric vehicles.

14. Method for producing an optical insulation-monitoring device (1) according to any of claims 1 to 7, comprising the method steps of: providing a polymer film (7) and introducing optical waveguides (6) and coupling elements (9) into the polymer film (7), the optical waveguides (6) being introduced by imprinting and/or inscribing and/or flex printing, and/or the coupling elements (9) being produced by means of nanoimprint printing and/or microscopeprojection photolithography and/or maskless lithography, providing a cable with at least one electrical conductor, and surrounding the cable with the at least one polymer film (7).

## Revendications

1. Contrôleur permanent d'isolement (1) optique pour câbles électriques (2), comprenant au moins un guide d'ondes lumineuses (6) pour la transmission d'un signal de mesure optique, dans lequel
il est prévu une pluralité de guides d'ondes lumineuses (6) qui sont conçus chacun pour transporter un signal de mesure optique associé,
il est prévu un élément de couplage (9) respectif aux extrémités des guides d'ondes lumineuses (6) pour l'injection et/ou l'extraction des signaux de mesure optiques dans les guides d'ondes lumineuses (6),
**caractérisé en ce que**
les guides d'ondes lumineuses (6) sont intégrés dans un film polymère (7), les éléments de couplage (9) sont constitués chacun d'une zone du film polymère (7) présentant deux polymères différents, les différents polymères se distinguant de par leurs indices de réfraction.

2. Contrôleur permanent d'isolement optique selon la revendication 1, **caractérisé en ce que** les guides d'ondes lumineuses (6) sont intégrés en couches dans le film polymère (7), les guides d'ondes lumineuses (6) d'une couche étant décalés par rapport aux guides d'ondes lumineuses (6) d'une autre couche.

3. Contrôleur permanent d'isolement optique selon la revendication 1 ou 2, **caractérisé en ce que** les guides d'ondes lumineuses (6) sont disposés avec recouvrement continu dans au moins une surface partielle du film polymère (7).

4. Contrôleur permanent d'isolement optique selon la revendication 1, **caractérisé en ce que** les éléments de couplage (9) sont conçus pour dévier les signaux de mesure perpendiculairement à leur direction de transmission dans les guides d'ondes lumineuses (6).

5. Contrôleur permanent d'isolement optique selon l'une des revendications 1 à 4,
**caractérisé en ce que** les éléments de couplage (9) sont intégrés dans des zones partielles associées des guides d'ondes lumineuses (6).

6. Contrôleur permanent d'isolement optique selon l'une des revendications 1 à 5,
**caractérisé en ce que** les éléments de couplage (9) sont regroupés en au moins un réseau (10, 11).

7. Contrôleur permanent d'isolement optique selon la revendication 6, **caractérisé en ce que** les éléments de couplage (9) d'un premier réseau (10) sont conçus pour l'injection des signaux de mesure, et les éléments de couplage (9) d'un deuxième réseau (11) sont conçus pour l'extraction des signaux de mesure.

8. Dispositif de contrôle permanent d'isolement comportant un contrôleur permanent d'isolement optique selon la revendication 7,
**caractérisé en ce qu'**une DEL est couplée au premier réseau (10) pour l'émission des signaux de mesure, et un élément de caméra CCD est couplé au deuxième réseau (11) pour la lecture des signaux de mesure.

9. Dispositif de contrôle permanent d'isolement selon la revendication 8, **caractérisé en ce qu'**il est conçu pour fournir de la lumière d'une longueur d'onde uniforme aux guides d'ondes lumineuses (6).

10. Câble comprenant un câble électrique (2) et un contrôleur permanant d'isolement (1) optique selon l'une des revendications 1 à 8,
**caractérisé en ce que** le film polymère (7) est disposé de telle sorte que la surface radiale extérieure du câble électrique (2) est entièrement entourée par le film polymère (7) au moins dans un tronçon longitudinal du câble.

11. Câble selon la revendication 10,
**caractérisé en ce qu'**il est prévu une gaine textile, la gaine entourant avec contact le film polymère (7) et le câble électrique (2) au moins dans le tronçon longitudinal contrôlé.

12. Câble selon la revendication 11,
**caractérisé en ce que** la gaine textile contient ou est constituée d'un tissu de fibres chimiques synthétiques à base de polyéthylène.

13. Utilisation d'un câble selon l'une des revendications 10 à 12 comme câble de charge rapide pour charger des véhicules électriques.

14. Procédé de fabrication d'un contrôleur permanent d'isolement (1) optique selon l'une des revendications 1 à 7, comprenant les étapes consistant à :
fournir un film polymère (7) et intégrer des guides d'ondes lumineuses (6) et des éléments de couplage (9) dans le film polymère (7), les guides d'ondes lumineuses (6) étant intégrés par estampage et/ou par inscription et/ou par flexographie, et/ou les éléments de couplage (9) étant réalisés par nanoimpression et/ou par photolithographie de projection au microscope et/ou par lithographie sans masque,
fournir un câble comprenant au moins un conducteur électrique, et
entourer le câble avec ledit au moins un film polymère (7).
